# EUROPEAN PATENT APPLICATION

(11) **EP 2 381 354 A2**
(43) Date of publication of application: **26.10.2011**
(21) Application number: 11163312.9
(22) Date of filing: 21.04.2011
(51) Int. Cl.: G06F 3/06, G06F 12/02

(54) **Data recording device**

(30) Priority: 22.04.2010 JP 2010098559
(71) Applicant: Funai Electric Co., Ltd., Daito-shi, Osaka (JP)
(72) Inventor: Suzuki, Takuya, Daito-shi Osaka (JP)
(74) Representative: Grünecker, Kinkeldey, Stockmair & Schwanhäusser

(57) **Abstract**

A data recording device is communicatable with a host device. A memory has a data recording area which is divided into a plurality of blocks. A controller is configured to perform writing of data with respect to the blocks in response to a data writing request from the host device and to perform rewriting of data in each blocks. When the controller performs the writing of data, the controller obtains update frequency information regarding the data to be written from the host device, selects one of the blocks based on the update frequency information, and writes the data to the one of the blocks.

## Description

The disclosure of Japanese Patent Application No. 2010-098559 filed on April 22, 2010, including specification, drawings and claims is incorporated herein by reference in its entirety.

### BACKGROUND

The present invention relates to a data recording device such as an SSD (Solid State Device).

An SSD is a high capacity semiconductor memory device which does not have movable portions. SSDs have high data transmission speed, short access times, excellent impact and vibration resistance and consume little power. Therefore, SSDs have been garnering attention recently as a new data recording device in place of the magnetic hard disk drives (HDD) used hitherto.

As the data recording medium of an SSD, a flash memory is generally used. Although there are two types of flash memory including an NAND type and an NOR type, in an SSD, the NAND type, which is capable of high-speed writing and has a high storage capacity, is used. However, in the NAND type of flash memory, the recording area is divided into a plurality of blocks, and data rewriting is performed in units of blocks. Accordingly, when rewriting of data is concentrated on the same block, there is a problem in that a memory cell of the block deteriorates since voltage is repeatedly applied thereto and the life of the flash memory is shortened.

As a countermeasure against this problem, a technique is known in which the rewriting is equalized over the entire recording area so that the rewriting of data is not concentrated on a certain block. For example, patent document 1 includes a disclosure in which variations of the number of rewrites between blocks are suppressed by providing a recording area for recording the number of rewrites performed on a block in an information recording medium capable of rewriting data per block and by performing rewriting from a block where the number of rewrites is small. Patent document 2 includes a disclosure in which the life of the data recording device is extended by making the search order for unused blocks be performed as a rotation in order to reduce the gap in the frequency of use between blocks. Patent document 3 discloses a cyclical recording method for avoiding repeatedly recording data on the same area.
Patent document 1: JP-A-7-85603
Patent document 2: JP-A-2003-271439
Patent document 3: PCT Japanese Patent Domestic Re-publication No. 2005-76275

In methods of equalizing the rewriting of data used hitherto, the attributes of the data have not been considered. Accordingly, for example, data having a low update frequency, such as program files, is stored in blocks where the number of rewrites is small, or, conversely, data having a high update frequency, such as document files, is stored in blocks where the number of rewrites is great. This results in an imbalance in data arrangement in the recording area and is likely to be a factor inhibiting the extension of the life of the data recording device.

### SUMMARY

It is therefore an object of at least one embodiment of the present invention to provide a data recording device with an extended life by writing data decentrally in a rational manner in consideration of the update frequency of the data to be written.

According to an aspect of the embodiments of the present invention, there is provided a data recording device which is communicatable with a host device, the data recording device comprising: a memory having a data recording area which is divided into a plurality of blocks; a controller configured to perform writing of data with respect to the blocks in response to a data writing request from the host device and to perform rewriting of data in each blocks, wherein when the controller performs the writing of data, the controller obtains update frequency information regarding the data to be written from the host device, selects one of the blocks based on the update frequency information, and writes the data to the one of the blocks.

In this manner, the data is written to a block which is selected in accordance with the update frequency of the data to be written. Therefore, when the update frequency of the data is high, it is possible to write the data to a block having a low number of rewrites; also, when the update frequency of the data is low, it is possible to write the data to a block having a great number of rewrites. As a result, it is possible to write the data decentrally in a rational manner according to the update frequency.

In the data recording device, the update frequency information may be an update frequency value which is calculated in accordance with an attribute of the data to be written, the controller may be configured to compares the update frequency value of the data to be written with a reference value, when the update frequency value is equal to or greater than the reference value, the data may be written to one of the blocks, where the number of data rewrites is less than a predetermined count, and when the update frequency value is less than the reference value, the data may be written to another of the blocks, where the number of data rewrites is equal to or greater than the predetermined count.

In the data recording device, the update frequency value may be calculated in accordance with at least one of a creator of the data to be written, a storage location of the data to be written, an extension of the data to be written, and a creation date of the data to be written.

For example, the update frequency value in a case where the creator of the data to be written is a user may be greater than the update frequency value in a case where the creator of the data to be written is not a user. The update frequency value in a case where the storage location of the data to be written is a storage location for user or for temporary storage use may be greater than the update frequency value in a case where the storage location of the data to be written is not a storage location for user or for temporary storage use. The update frequency value in a case where the extension of the data to be written is an extension indicating a document file or a spreadsheet file may be greater than the update frequency value in a case where the extension of the data to be written is not an extension indicating the document file or the spreadsheet file. The update frequency value in a case where the creation date of the data to be written is within a predetermined period counting back from the current date may be greater than the update frequency value in a case where the creation date of the data to be written is not within the predetermined period counting back from the current date.

According to the aspect of the embodiments of the present invention, it is possible to write data decentrally in a rational manner by taking the update frequency of the data to be written into consideration. Therefore, it is possible to resolve the imbalance in data arrangement in the recording area and extend the life of the device.

### BRIEF DESCRIPTION OF THE DRAWINGS

In the accompanying drawings:
Fig. 1 is a block diagram of an SSD according to an embodiment of the invention;
Fig. 2 is a view showing a data recording area;
Fig. 3 is a view showing a table of the number of rewrites;
Fig. 4 is a view showing an address conversion table;
Fig. 5 is a flowchart showing a data recording procedure;
Fig. 6 is a flowchart showing a calculation procedure of an update frequency value;
Fig. 7 is a flowchart showing a calculation procedure of the update frequency value according to another embodiment; and
Fig. 8 is a flowchart showing a data recording procedure according to another embodiment.

### DETAILED DESCRIPTION OF THE EMBODIMENTS

Hereinafter, an embodiment in a case where the invention is applied to an SSD (Solid State Device) will be described with reference to the drawings.

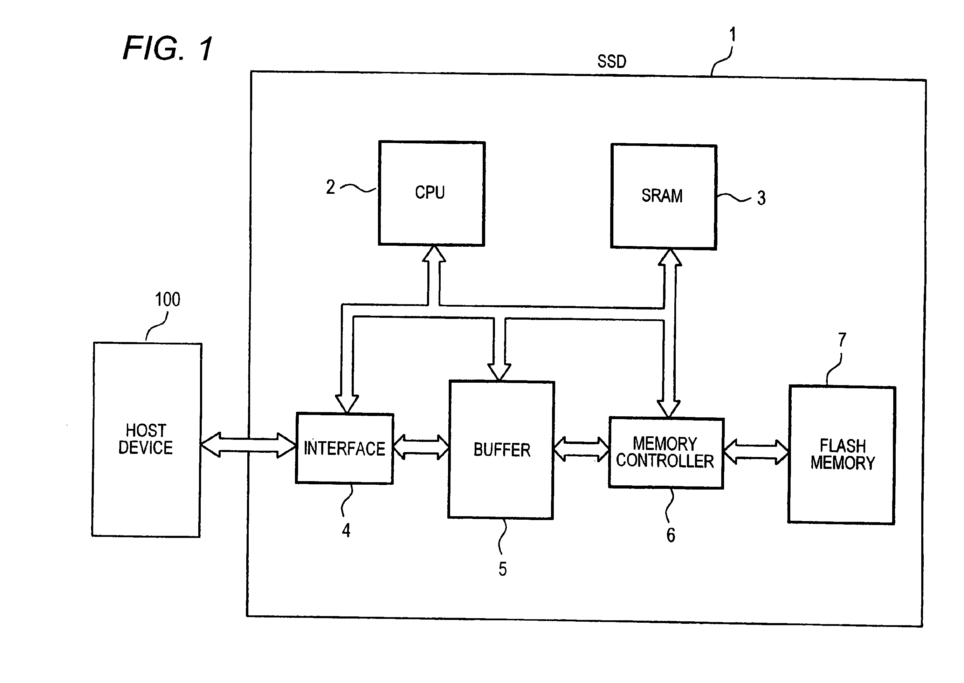

First, the configuration of the SSD according to the embodiment of the invention will be described based on Figs. 1 to 4. In Fig. 1, an SSD 1 includes a CPU 2, an SRAM (Static Random Access Memory) 3, an interface 4, a buffer 5, a memory controller 6 and a flash memory 7.

The CPU 2 controls the operation of respective portions of reference numerals 3 to 6, as a controller. SRAM 3 is provided with a rewrite count table, an address conversion table and the like which will be described later. The interface 4 is communicatable with a host device 100. The interface 4 includes a PATA (Parallel Advanced Technology Attachment), an SATA (Serial Advanced Technology Attachment), an SCSI (Small Computer System Interface), an SAS (Serial Attached SCSI) and the like, and exchanges data with the host device 100. The buffer 5 includes a DRAM (Dynamic Random Access Memory) for example, and temporarily stores the data which is sent from the host device 100 via the interface 4. The memory controller 6 performs control to write the data of the buffer 5 in the flash memory 7. The flash memory 7 is a non-volatile memory maintaining the content stored therein even after power is shut off and includes a plurality of NAND type flash memories.

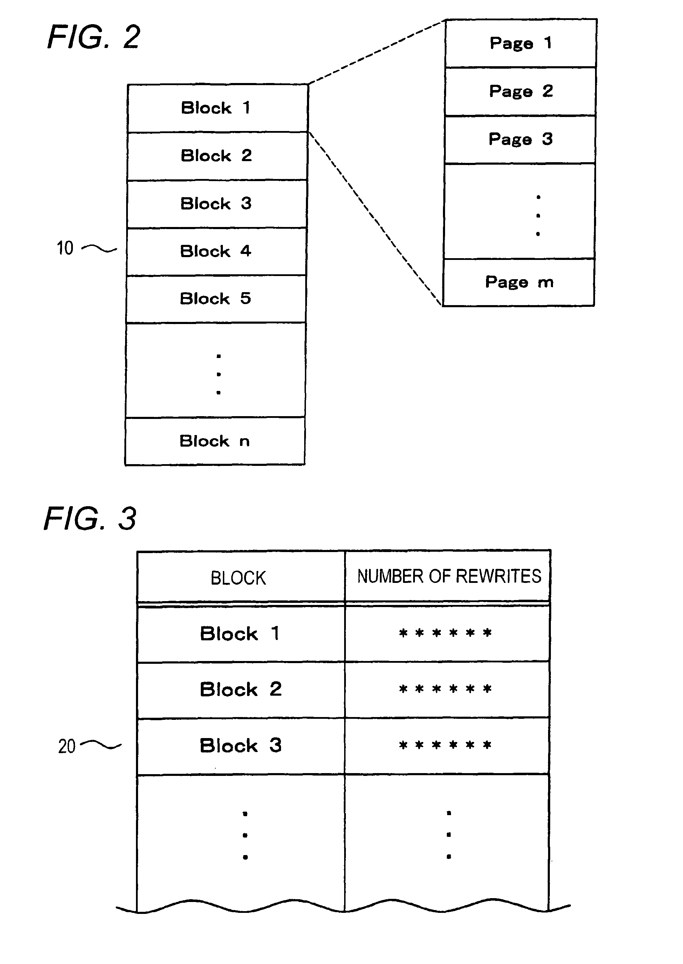

Fig. 2 shows a data recording area in the flash memory 7. The data recording area 10 is divided into a plurality of blocks, and each block is constituted with a plurality of pages (also referred to as sectors). In order to write data to the flash memory 7, it is necessary to write new data after collectively deleting the data in a block which is the writing destination. In this case, the minimum unit in which the data can be deleted is a block, and rewriting of the data is performed per block. Also, the minimum unit for reading and writing of data is a page.

Fig. 3 shows a rewrite count table provided in the SRAM 3. In a rewrite count table 20, the number of times by which the data has been rewritten to blocks in the data recording area 10 of Fig. 2 is recorded for each block.

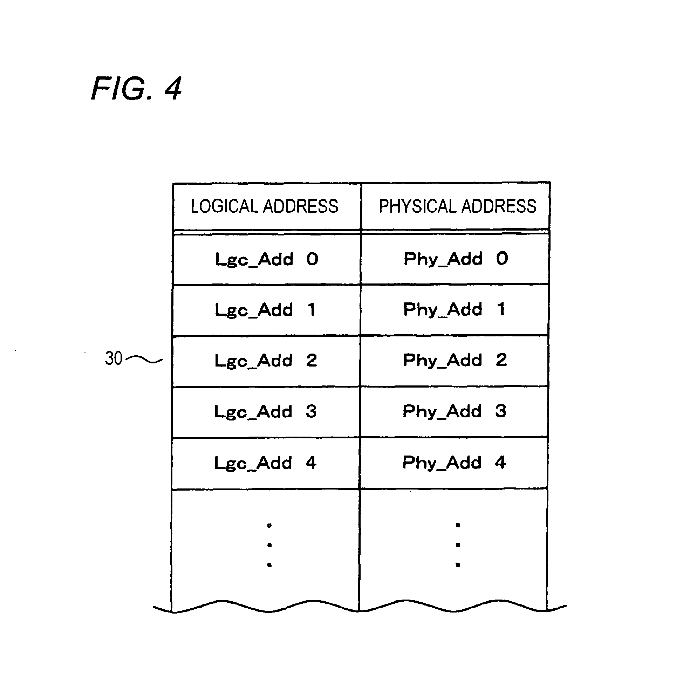

Fig. 4 shows an address conversion table provided in the SRAM 3. In an address conversion table 30, physical addresses corresponding to logical addresses of the flash memory 7 are recorded. When the host device 100 accesses the SSD 1, the recording area is designated by the logical address of the flash memory 7, with the page set as the unit. Meanwhile, the physical address of the flash memory 7 is not fixedly allocated with respect to the logical address, but dynamically allocated according to data updates. Accordingly, whenever the data is rewritten, the content of the address conversion table is updated.

Next, data recording performed in the SSD 1 including the above configuration will be described in detail. First, the data update frequency information as a feature of the invention will be described.

Although there are various types of data that are recorded in the SSD 1, some of them are updated (rewritten) frequently, and some of them are almost never updated.

For example, when the data creator is considered as a main focus, files created by the users themselves are highly likely to be updated; however, executable files or the like created by a company are less likely to be updated.

Further, when the data storage location is considered as a main focus, for example, files stored in storage locations used by the user or for temporary storage, such as the home directory (/home) or the temporary directory (/tmp) in Linux (registered trademark), are highly likely to be updated; however, basic command files stored in the binary directory (/bin) are less likely to be updated.

In addition, when the data extension is considered as a main focus, a file with the "doc" extension indicating a document file, or the "xls" extension indicating a spreadsheet file is highly likely to be updated; however, a file with the "exe" extension indicating a program file, or a file with the "lib" extension indicating a library file is less likely to be updated.

Hence, the host device 100 calculates the update frequency value in advance according to the attributes of the data as described above, with respect to the data (file) to be written to the SSD 1. When the data is written, the host device 100 notifies the SSD 1 of the calculated update frequency value. Thereafter, based on the update frequency value obtained from the host device 100, the SSD 1 selects a block in which the data will be written and writes the data to the corresponding block (detailed description will be made later).

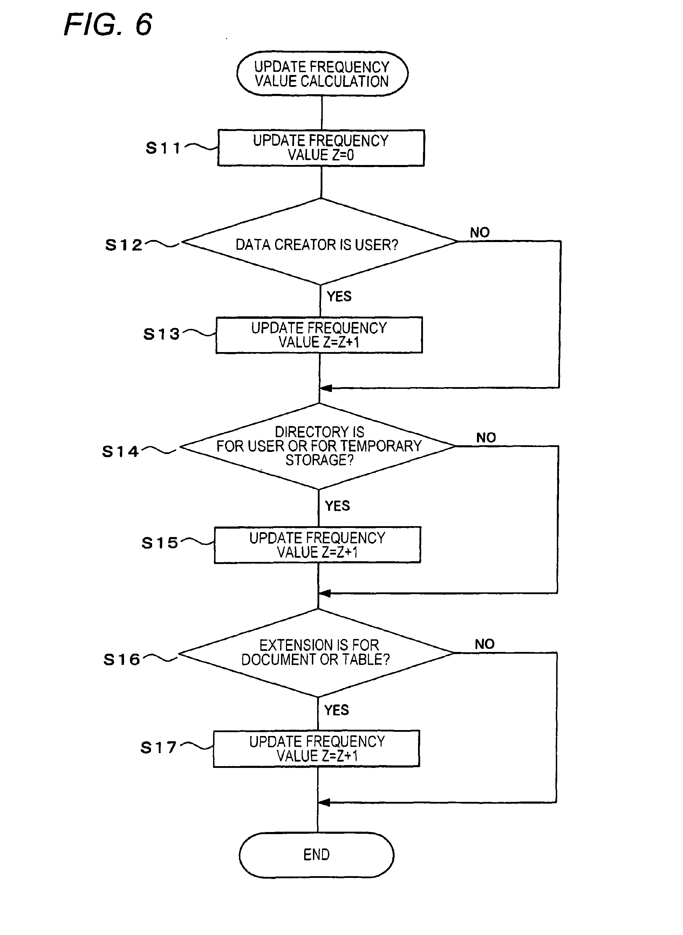

Fig. 6 is a flowchart showing an example of a procedure of calculating the update frequency value in the host device 100. In step S11, initialization of an update frequency value Z is performed to yield Z=0. In the following step S12, it is determined whether the data to be written to the SSD I is a file created by the user. When the data is a file created by the user (step S12: YES), the process moves on to step S 13 in which 1 is added to the update frequency value Z to yield Z=Z+1. Subsequently, the process moves on to step S14. On the other hand, when the data is not a file created by the user (step S12: NO), step S13 is skipped, and the process moves on to step S14.

In step S 14, it is determined whether the directory of the file is a directory (for example, "/home" or "/tmp") for the user or temporary storage use. When the directory is for the user or for temporary storage use (step S14: YES), the process moves on to step S15 in which 1 is added to the update frequency value Z to yield Z=Z+1. Thereafter, the process moves on to step S16. On the other hand, when the directory is not for the user or temporary storage use (step S14: NO), step S15 is skipped, and the process moves on to step S16.

In step S16, it is determined whether the extension of the file is an extension indicating a document file or a spreadsheet file (for example, "doc" or "xls"). When it is an extension indicating a document file or a spreadsheet file (step S16: YES), the process moves on to step S17 in which 1 is added to the update frequency value Z to yield Z=Z+1. Subsequently, the process ends. On the other hand, when the extension does not indicate a document file or a spreadsheet file (step S16: NO), step S17 is skipped, and the process ends.

According to the procedure in Fig. 6, the update frequency value is calculated in the following manner for example.
(1) When the file is created by the user (step S12: YES), the directory is for the user or temporary storage use (step S14: YES), and the extension is a document file or spreadsheet file extension (step S16: YES), the update frequency value Z becomes Z=3 through the operation in steps S13, S15 and S17.
(2) When the file is created by the user (step S12: YES), the directory is not for the user or temporary storage use (step S14: NO), and the extension is a document file or spreadsheet file extension (step S16: YES), the update frequency value Z becomes Z=2 through the operation in steps S13 and S17.
(3) When the file is not created by the user (step S12: NO), the directory is for the user or temporary storage use (step S14: YES), and the extension is not a document file or spreadsheet file extension (step S16: NO), the update frequency value Z becomes Z=1 through the operation in step S15.
(4) When the file is not created by the user (step S12: NO), the directory is not for the user or temporary storage use (step S14: NO), and the extension is not a document file or spreadsheet file extension (step S16: NO), the update frequency value Z becomes Z=0 since steps S 13, S 15 and S 17 are not performed.

In this manner, the update frequency value according to the data attributes is calculated in the host device 100.

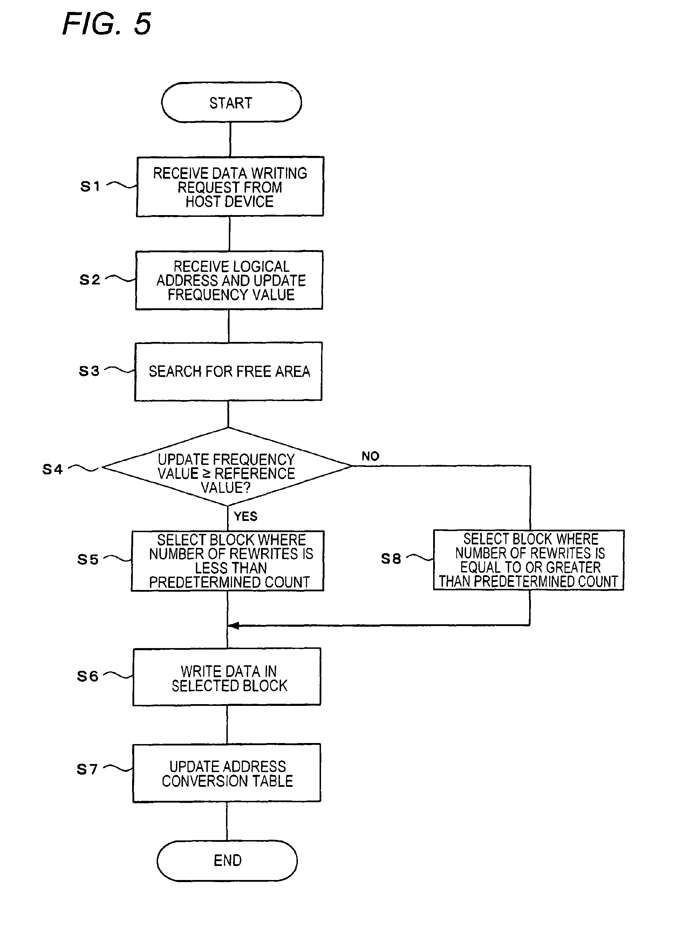

Next, the procedure of recording data based on the above-described update frequency value in the SSD I will be described on the basis of the flowchart in Fig. 5. Each step in the flowchart is performed by the CPU 2.

In step S1, a data writing request is received from the host device 100. In step S2, a logical address and the update frequency value transmitted from the host device 100 after the data writing request are received. In the following step S3, a free area is searched for in the data recording area 10 of the flash memory 7.

Subsequently, in step S4, the update frequency value received in step S2 is compared to the reference value, and it is determined whether the update frequency value is equal to or greater than the reference value. When it is determined that the update frequency value is equal to or greater than the reference value as a result (step S4: YES), the process moves on the step S5.

In step S5, a block where the number of data rewrites is less than a predetermined number is selected from among the free areas extracted in step S3. When there is a plurality of the corresponding blocks, a block with the least number of rewrites is selected by priority.

In the following step S6, the data is written to the block selected in step S5. Before writing, the data that has been in the corresponding block is collectively deleted by the memory controller 6. Furthermore, the physical address corresponding to the logical address obtained in step S2 is extracted based on the address conversion table 30, and the data that is not the target of the rewriting in the page corresponding to the physical address is copied to a block which is the writing destination. Thereafter, the data stored in the buffer 5 is transmitted to the flash memory 7 by the memory controller 6 and written to the block as a writing destination. In this manner, since the data in the corresponding block is rewritten, 1 is added to the number of rewrites of the corresponding block in the rewrite count table 20 (Fig. 3).

Thereafter, in step S7, the address conversion table 30 (Fig. 4) is updated. That is, the logical address obtained from the host device 100 in step S2 is associated with the physical address of the writing destination block selected in step S5, thereby rewriting the address conversion table 30.

Meanwhile, when it is determined in step S4 that the update frequency value is less than the reference value as a result (step S4: NO), the process moves on to step S8.

In step S8, a block where the number of data rewrites is equal to or greater than a predetermined count is selected from among the free areas extracted in step S3. When there is a plurality of the corresponding areas, the block with the greatest number of rewrites is selected by priority.

Subsequently, in step S6, the data is written to the selected block. The address conversion table 30 is updated in step S7, and the process ends.

In this manner, in the embodiment described above, the update frequency value calculated according to the data attributes is sent to the SSD I from the host device 100, and a block is selected according to the update frequency value in the SSD 1. Therefore, the data with a great update frequency value is written to a block with a low number of rewrites, and the data with a low update frequency value is written to a block with a great number of rewrites. As a result, it is possible to write the data decentrally in a rational manner according to the update frequency; therefore, it is possible to avoid issues where data which is less likely to be updated is concentrated in blocks where the number of rewrites is low or issues where data which is highly likely to be updated is concentrated in blocks where the number of rewrites is great. Accordingly, since the data is arranged in the data recording area 10 of the flash memory 7 with balance, it is possible to extend the life of the flash memory 7.

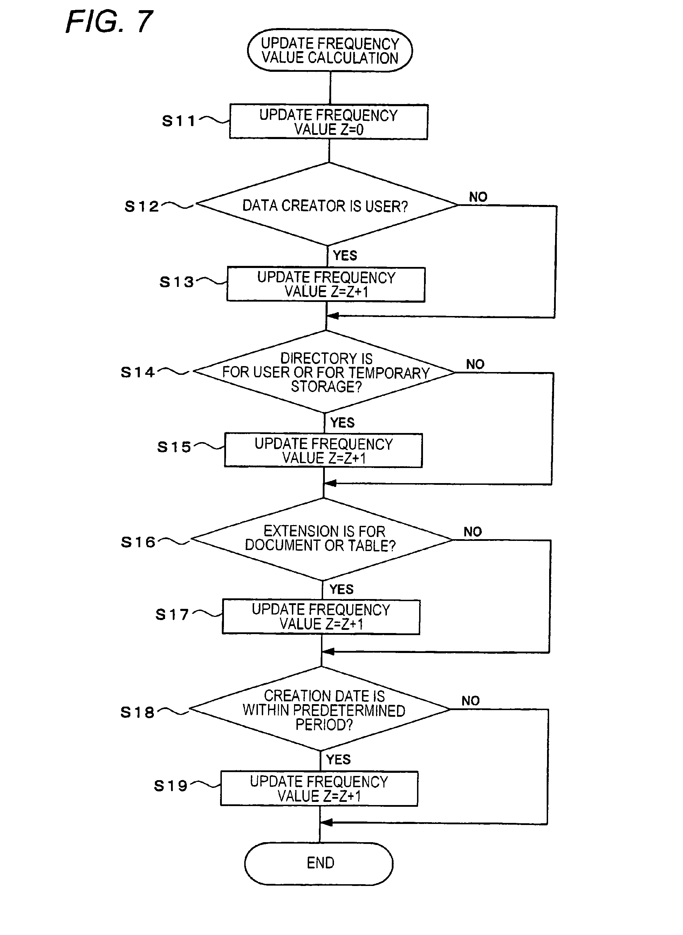

In the invention, various embodiments can be applied in addition to the embodiment described above. For example, in the above embodiment, the three data attributes of data creator, data storage location and extension were exemplified. However, the data creation date may be added as another attribute, and the calculation procedure of the update frequency value in this case is shown in Fig. 7.

In Fig. 7, steps S18 and S19 are added to steps S11 to S17 in Fig. 6. In step S 18, it is determined whether the data creation date is within a predetermined period (for example, within a year) counting back from the current date. When the data creation date is within the predetermined period (step S18: YES), the data is regarded as highly likely to be updated, and the process moves on to step S19 in which 1 is added to the update frequency value Z to yield Z=Z+1. Subsequently, the process ends. On the other hand, when the data creation date is not within a predetermined period counting back from the current date (step S18: NO), the data is regarded as less likely to be updated, so step S19 is skipped, and the process ends.

The attributes of data are not limited to the above four types and other attributes may be employed. For example, based on the type of data, the update frequency value may be divided according to whether the data is an executable file (the update frequency of an executable file is lower than the update frequency of other files). Also, the plurality of attributes need not all be employed, and a part thereof may be combined and employed, or any single attribute of them may be employed.

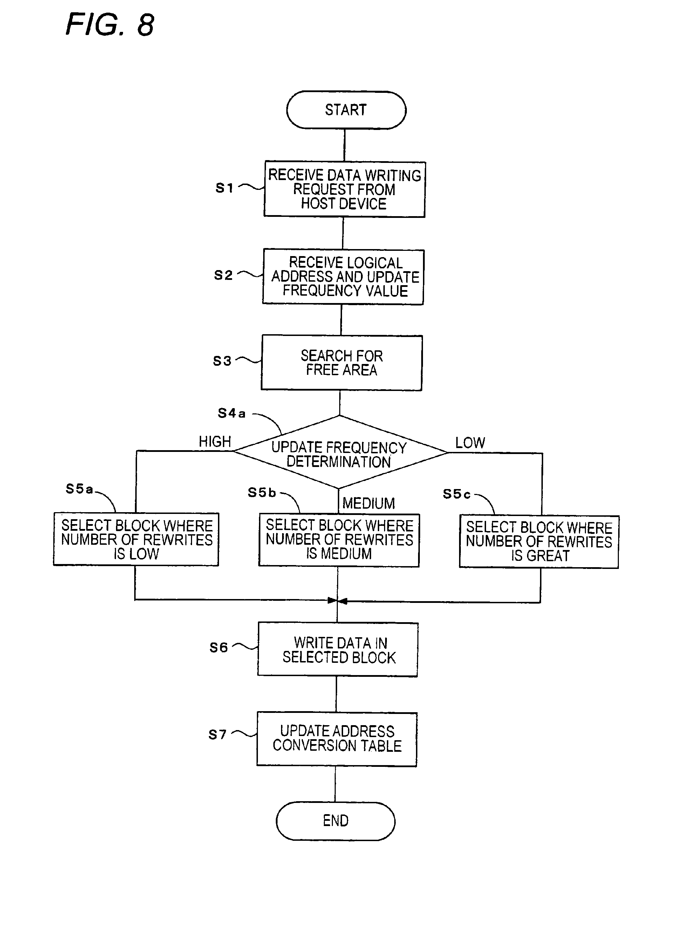

Moreover, although the update frequency value was compared to one reference value in the above embodiment, the update frequency value may be compared to a plurality of reference values. For example, a data recording procedure in a case where there are two reference values is shown in Fig. 8.

In Fig. 8, steps S4, S5 and S8 in Fig. 5 are replaced with steps S4a and S5a to S5c. In step S4a, the update frequency value of the data is compared to reference values α and β (α>β). When update frequency value≥α, the update frequency is regarded to be high, and a block where the number of rewrites is low is selected in step S5a. When α>update frequency value≥β, the update frequency is regarded to be medium and a block where the number of rewrites is medium is selected in step S5b. When update frequency value<β, the update frequency is regarded to be low, and a block where the number of rewrites is great is selected. The division of the number of rewrites in steps S5a to S5c is determined based on the two thresholds determined in advance.

Furthermore, in the above embodiment, the update frequency value calculated by the operation was employed as the update frequency information. However, ranks divided in advance according to the update frequency may be used as the update frequency information.

Moreover, in the above embodiment, an example in which the invention is applied to an SSD was exemplified. However, the invention can be applied to the semiconductor memory device such as an EEPROM (Electrically Erasable and Programmable Read Only Memory) without being limited to an SSD.

The invention is useful as a data recording device mounted on a personal computer, a disk recording and reproducing device, a digital television, a digital camera and the like.
Fig. 1
   - 100: HOST DEVICE
   - 4: INTERFACE
   - 5: BUFFER
   - 6: MEMORY CONTROLLER
   - 7: FLASH MEMORY
Fig. 3
   - A: BLOCK
   - B: NUMBER OF REWRITES
Fig. 4
   - A: LOGICAL ADDRESS
   - B: PHYSICAL ADDRESS
Fig. 5 START
   - S1: RECEIVE DATA WRITING REQUEST FROM HOST DEVICE
   - S2: RECEIVE LOGICAL ADDRESS AND UPDATE FREQUENCY VALUE
   - S3: SEARCH FOR FREE AREA
   - S4: UPDATE FREQUENCY VALUE ≥ REFERENCE VALUE?
   - S5: SELECT BLOCK WHERE NUMBER OF REWRITES IS LESS THAN PREDETERMINED COUNT
   - S8: SELECT BLOCK WHERE NUMBER OF REWRITES IS EQUAL TO OR GREATER THAN PREDETERMINED COUNT
   - S6: WRITE DATA IN SELECTED BLOCK
   - S7: UPDATE ADDRESS CONVERSION TABLE
   END
Fig. 6 UPDATE FREQUENCY VALUE CALCULATION
   - S11: UPDATE FREQUENCY VALUE Z = 0
   - S 12: DATA CREATOR IS USER?
   - S 13: UPDATE FREQUENCY VALUE Z = Z+1
   - S14: DIRECTORY IS FOR USER OR FOR TEMPORARY STORAGE?
   - S15: UPDATE FREQUENCY VALUE Z = Z+1
   - S16: EXTENSION IS FOR DOCUMENT OR TABLE?
   - S 17: UPDATE FREQUENCY VALUE Z = Z+1
   END
Fig. 7 UPDATE FREQUENCY VALUE CALCULATION
   - S11: UPDATE FREQUENCY VALUE Z = 0
   - S12: DATA CREATOR IS USER?
   - S13: UPDATE FREQUENCY VALUE Z = Z+1
   - S14: DIRECTORY IS FOR USER OR FOR TEMPORARY STORAGE?
   - S15: UPDATE FREQUENCY VALUE Z = Z+1
   - S 16: EXTENSION IS FOR DOCUMENT OR TABLE?
   - S 17: UPDATE FREQUENCY VALUE Z = Z+1
   - S18: CREATION DATE IS WITHIN PREDETERMINED PERIOD?
   - S 19: UPDATE FREQUENCY VALUE Z = Z+1
   END
Fig. 8 START
   - S1: RECEIVE DATA WRITING REQUEST FROM HOST DEVICE
   - S2: RECEIVE LOGICAL ADDRESS AND UPDATE FREQUENCY VALUE
   - S3: SEARCH FOR FREE AREA
   - S4a: UPDATE FREQUENCY DETERMINATION
   - S5a: SELECT BLOCK WHERE NUMBER OF REWRITES IS LOW
   - S5b: SELECT BLOCK WHERE NUMBER OF REWRITES IS MEDIUM
   - S5c: SELECT BLOCK WHERE NUMBER OF REWRITES IS GREAT
   - S6: WRITE DATA IN SELECTED BLOCK
   - S7: UPDATE ADDRESS CONVERSION TABLE
   END
   - A: HIGH
   - B: MEDIUM
   - C: LOW

## Claims

1. A data recording device which is communicatable with a host device, the data recording device comprising:
a memory having a data recording area which is divided into a plurality of blocks;
a controller configured to perform writing of data with respect to the blocks in response to a data writing request from the host device and to perform rewriting of data in each blocks,
wherein when the controller performs the writing of data, the controller obtains update frequency information regarding the data to be written from the host device, selects one of the blocks based on the update frequency information, and writes the data to the one of the blocks.

2. The data recording device as set forth in claim 1,
wherein the update frequency information is an update frequency value which is calculated in accordance with an attribute of the data to be written,
wherein the controller is configured to compares the update frequency value of the data to be written with a reference value,
wherein when the update frequency value is equal to or greater than the reference value, the data is written to one of the blocks, where the number of data rewrites is less than a predetermined count, and
wherein when the update frequency value is less than the reference value, the data is written to another of the blocks, where the number of data rewrites is equal to or greater than the predetermined count.

3. The data recording device as set forth in claim 2, wherein the update frequency value is calculated in accordance with at least one of a creator of the data to be written, a storage location of the data to be written, an extension of the data to be written, and a creation date of the data to be written.

4. The data recording device as set forth in claim 3, wherein the update frequency value in a case where the creator of the data to be written is a user is greater than the update frequency value in a case where the creator of the data to be written is not a user.

5. The data recording device as set forth in claim 3, wherein the update frequency value in a case where the storage location of the data to be written is a storage location for user or for temporary storage use is greater than the update frequency value in a case where the storage location of the data to be written is not a storage location for user or for temporary storage use.

6. The data recording device as set forth in claim 3, wherein the update frequency value in a case where the extension of the data to be written is an extension indicating a document file or a spreadsheet file is greater than the update frequency value in a case where the extension of the data to be written is not an extension indicating the document file or the spreadsheet file.

7. The data recording device as set forth in claim 3, wherein the update frequency value in a case where the creation date of the data to be written is within a predetermined period counting back from the current date is greater than the update frequency value in a case where the creation date of the data to be written is not within the predetermined period counting back from the current date.
